# EUROPEAN PATENT APPLICATION

(11) **EP 4 597 807 A1**
(43) Date of publication of application: **06.08.2025**
(21) Application number: 22961004.3
(22) Date of filing: 30.09.2022
(51) Int. Cl.: H02K 15/02, G01N 29/265

(54) **ROTATING ELECTRIC MACHINE INSPECTION DEVICE, ROTATING ELECTRIC MACHINE INSPECTION SYSTEM, AND ROTATING ELECTRIC MACHINE INSPECTION METHOD**

(71) Applicant: Mitsubishi Generator Co., Ltd., Kobe City, Hyogo 652-8555 (JP)
(72) Inventor: GOTO, Daichi, Tokyo 100-8310 (JP); MORIMOTO, Yoshihiro, Tokyo 100-8310 (JP); NAKANE, Yusuke, Tokyo 100-8310 (JP)
(74) Representative: Witte, Weller & Partner Patentanwälte mbB
(86) International application number: PCT/JP2022/036733
(87) International publication number: WO 2024/069945

(57) **Abstract**

An inspection device (1) inspects an inspection target part (120) by being inserted into a gap (103) between a stator (102) and a rotor (101) of a rotary electric machine (100). The inspection device (1) includes: a traveling body (111, 112) which is attached to a base frame (21) and moves the base frame (21) in an axial direction (Y) in the gap (103); a probe (31) which inspects the inspection target part (120); a radial-movement portion (20) which moves the probe (31) in a radial direction (X) perpendicular to the axial direction (Y) and a circumferential direction (Z); a circumferential-movement portion (30) which moves the probe (31) in the circumferential direction (Z) in the base frame (21); and a roller (38) provided at an end in the axial direction of the probe (31) and containing a contact medium. The probe (31) has an ultrasonic sensor (311) and a shoe (312) formed by an elastic member, and the probe (31) inspects the inspection target part (120) along the axial direction in a state in which a side where the roller (38) is provided is set as a front side.

## Description

### TECHNICAL FIELD

The present disclosure relates to a rotating electric machine inspection device, a rotating electric machine inspection system, and a rotating electric machine inspection method.

### BACKGROUND ART

A wedge for retaining a winding is attached to a groove of a rotor of a rotating electric machine. During operation of the rotating electric machine, the wedge is subjected to a centrifugal force by the winding in the groove and the wedge itself, so that a crack might occur at a surface of the wedge or inside thereof. The crack occurring at the wedge of the rotor can cause failure of the rotating electric machine. Therefore, it is recommended that, in accordance with operation years and operation conditions, the rotor is pulled out from a stator and a crack occurrence condition is inspected.

In conventional inspection for the wedge of the rotating electric machine, a long stop period is needed due to work for pulling out the rotor, the cost is high, the utilization factor is reduced, and the stator and the rotor might be damaged. Therefore, a method for inspecting the rotating electric machine without pulling out the rotor from the stator is proposed. For example, Patent Document 1 discloses a device and a method for performing inspection remotely by inserting the device between a stator and a rotor of a rotating electric machine without disassembling the stator and the rotor of the rotating electric machine.

### CITATION LIST

### PATENT DOCUMENT

Patent Document 1: Japanese Laid-Open Patent Publication No. 2017-138315
Patent Document 2: Japanese Patent No. 7080411

### SUMMARY OF THE INVENTION

### PROBLEM TO BE SOLVED BY THE INVENTION

In the conventional rotating electric machine inspection device, when the rotating electric machine is stopped, the rotor can stop at any angle relative to arrangement of teeth of the stator, and this is not taken into consideration sufficiently. Thus, there is a problem that a rotor wedge range where a device attracted at a tooth of the stator can perform inspection is constrained by a position on the stator at which the device is attracted.

In addition, in a case of inspecting all wedges of the rotor of the rotating electric machine against constraints of a movement range in the circumferential direction, the device needs to be moved from a tooth to another tooth of the stator and placed there many times, so that an inspection period is prolonged, thus having a problem that efficiency of inspection work is reduced.

Further, in a case where two or more wedges of the rotor are present between adjacent stator teeth, when the device is placed, the position of the device cannot be finely controlled relative to arrangement of wedges of the stator, so that there might be some wedges for which a probe cannot properly contact with surfaces thereof. In a case of inspecting such wedges with which the probe cannot contact, the stopped rotor needs to be rotated to adjust the rotation position. However, rotating the rotor having a weight of several tons to several tens of tons at each time has a problem that efficiency of inspection work is reduced.

The applicant has disclosed the technology described in Patent Document 2, as a technology for solving the above problems.

Meanwhile, in particular, an inspection device directed to a large-sized rotating electric machine requires a long time for inspection. Therefore, it is required that the inspection time is shortened without reduction in inspection accuracy.

The present disclosure has been made to solve the above problem, and an object of the present disclosure is to provide a rotating electric machine inspection device, a rotating electric machine inspection system, and a rotating electric machine inspection method that enable the inspection time to be shortened without reduction in inspection accuracy.

### MEANS TO SOLVE THE PROBLEM

A rotating electric machine inspection device according to the present disclosure is a rotating electric machine inspection device which inspects an inspection target part by being inserted into a gap between an inner circumferential surface of a stator and an outer circumferential surface of a rotor of a rotating electric machine, the rotating electric machine inspection device including: a base frame; a traveling body which is attached to the base frame and moves the base frame in an axial direction in the gap; a probe which inspects the inspection target part and has an ultrasonic sensor of a phased-array type and a shoe provided at one surface of the ultrasonic sensor and formed by an elastic member; a radial-movement portion which moves the probe in a radial direction perpendicular to the axial direction and a circumferential direction; a circumferential-movement portion which moves the probe in the circumferential direction in the base frame; and a roller provided at an end in the axial direction of the probe and containing a contact medium, wherein the probe inspects the inspection target part along the axial direction in a state in which a side where the roller is provided is set as a front side.

### EFFECT OF THE INVENTION

The rotating electric machine inspection device, the rotating electric machine inspection system, and the rotating electric machine inspection method according to the present disclosure enable the inspection time to be shortened without reduction in inspection accuracy.

### BRIEF DESCRIPTION OF THE DRAWINGS

[FIG. 1] FIG. 1 is a schematic diagram showing the configurations of a rotating electric machine, a rotating electric machine inspection device, and a rotating electric machine inspection system according to embodiment 1.
[FIG. 2] FIG. 2 is a perspective view showing the schematic configuration of the inspection device shown in FIG. 1.
[FIG. 3] FIG. 3 is an exploded perspective view illustrating the schematic configuration of the inspection device shown in FIG. 2.
[FIG. 4] FIG. 4 is a sectional view along an axial direction, showing the states of the rotating electric machine and the inspection device shown in FIG. 1.
[FIG. 5] FIG. 5 is a sectional view as seen in the axial direction, illustrating an inspection method using the inspection device according to embodiment 1.
[FIG. 6] FIG. 6 is a sectional view along the axial direction, illustrating the inspection method using the inspection device according to embodiment 1.
[FIG. 7] FIG. 7 is a sectional view of the inspection device and the rotating electric machine shown in FIG. 4.
[FIG. 8] FIG. 8 is a sectional view of the inspection device and the rotating electric machine shown in FIG. 4.
[FIG. 9] FIG. 9 is a schematic enlarged view of the inspection device and the rotating electric machine shown in FIG. 8.
[FIG. 10] FIG. 10 is a schematic enlarged view of the inspection device and the rotating electric machine shown in FIG. 8 and is an axial-direction vertical sectional view.
[FIG. 11] FIG. 11 illustrates an acquisition method for cross-section data using the inspection device according to embodiment 1.
[FIG. 12A] FIG. 12A is a flowchart showing the inspection method by the rotating electric machine inspection device shown in FIG. 1.
[FIG. 12B] FIG. 12B is a flowchart showing the inspection method by the rotating electric machine inspection device shown in FIG. 1.

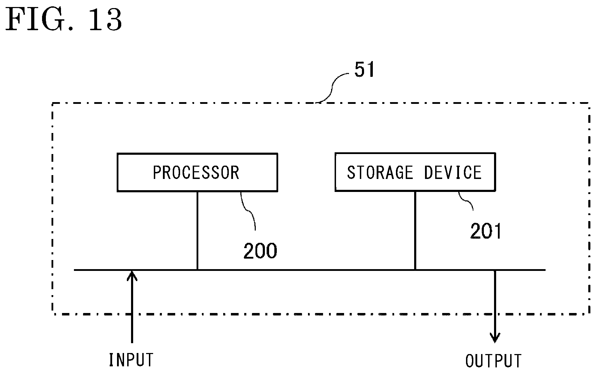

[FIG. 13] FIG. 13 is a hardware configuration diagram showing an example of a control unit of the rotating electric machine inspection device shown in FIG. 1.

### DESCRIPTION OF EMBODIMENTS

The present disclosure is for performing inspection for an inspection target part of a rotating electric machine through remote control by inserting an inspection device into a gap between a stator and a rotor of the rotating electric machine while the stator and the rotor of the rotating electric machine remain combined. Therefore, as a matter of course, the inspection device has such a dimension setting and a configuration that the inspection device can be placed in the gap between the stator and the rotor of the rotating electric machine. In the following description of embodiments, directions of the rotating electric machine are defined as a circumferential direction Z, an axial direction Y, and a radial direction X. Therefore, also in the stator and the rotor, the same directions are applied. In addition, the inspection device of the present disclosure is described using these directions as a reference.

### Embodiment 1

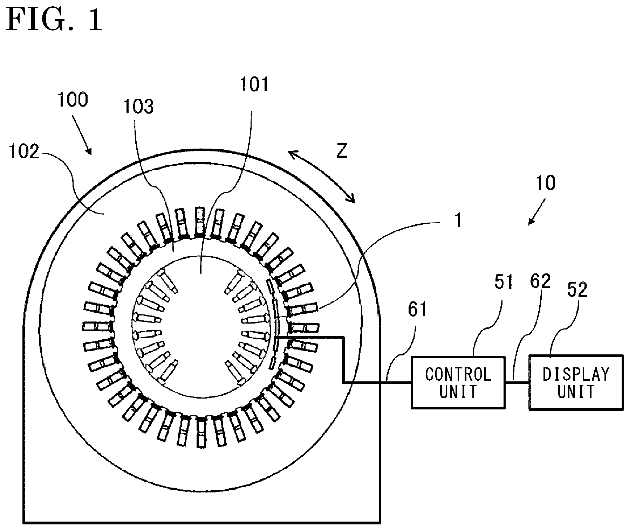

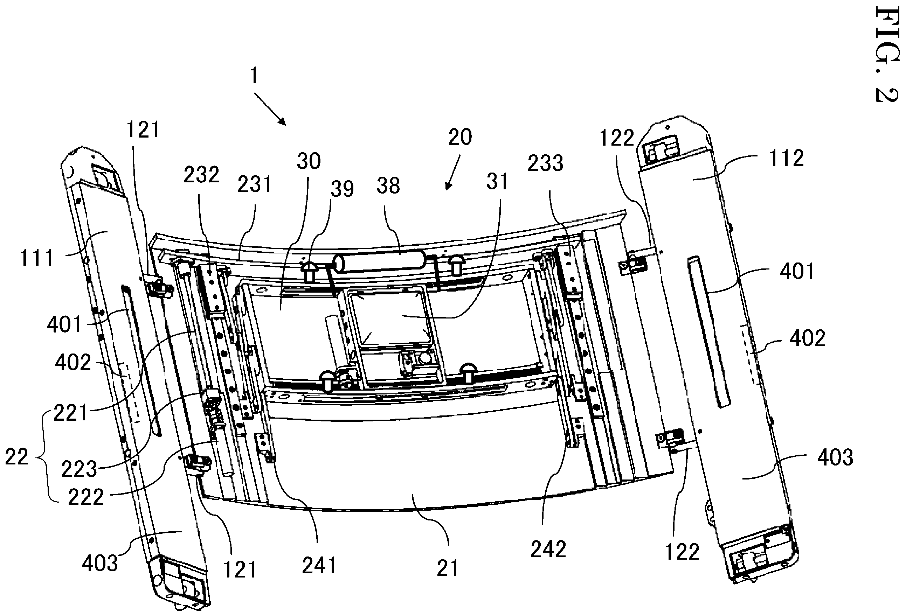

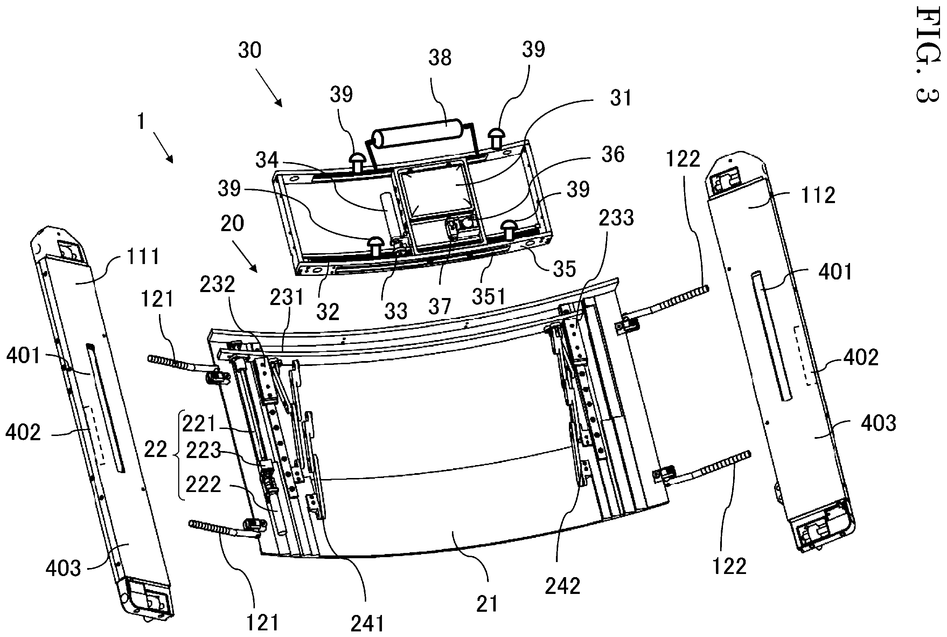

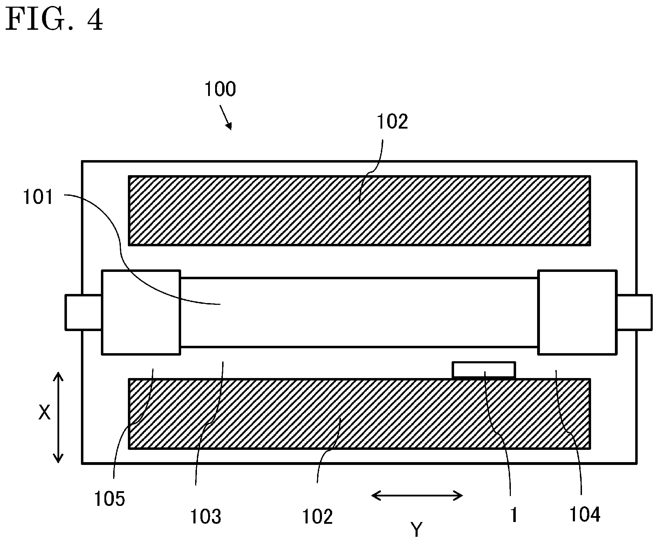

FIG. 1 is a schematic diagram showing the configurations of a rotating electric machine, a rotating electric machine inspection device, and a rotating electric machine inspection system according to embodiment 1. FIG. 2 is a schematic perspective view showing the configuration of the inspection device shown in FIG. 1. FIG. 3 is a schematic exploded perspective view showing the configuration of the inspection device shown in FIG. 2. FIG. 4 is a schematic sectional view along the axial direction, showing the states of the rotating electric machine and the inspection device shown in FIG. 1.

In FIG. 1, a rotating electric machine 100 includes a stator 102 and a rotor 101 provided on the inner side of the stator 102 with a gap 103 therebetween. A rotating electric machine inspection device 1 (hereinafter, referred to as inspection device) which inspects the rotating electric machine 100 has such a dimension setting and a configuration that the inspection device 1 can be inserted and placed in the gap 103 between the inner circumferential surface of the stator 102 and the outer circumferential surface of the rotor 101 of the rotating electric machine 100, and the inspection device 1 inspects an inspection target part.

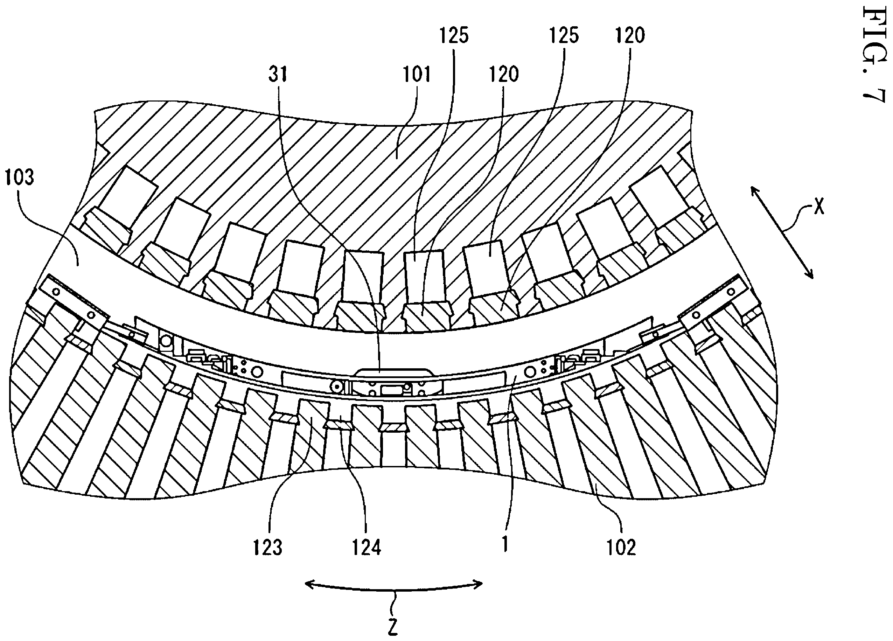

A rotating electric machine inspection system 10 (hereinafter, referred to as inspection system) includes the inspection device **1,** a control unit 51 which controls movement of a probe 31 of the inspection device 1 in at least one of the circumferential direction Z and the radial direction X, and a display unit 52 which displays the state of the inspection device 1. The control unit 51 in embodiment 1 controls movement of the probe 31 in both of the circumferential direction Z and the radial direction X. FIG. 1 shows a state in which the inspection device 1 is placed at a certain position in the gap 103. However, since the inspection device 1 is magnetically attracted to teeth 123 (see FIG. 7) of a core of the stator 102 formed by a ferromagnetic body at the inner circumferential surface of the stator 102, the inspection device 1 can be placed along the teeth 123 of the core of the stator 102 formed by a ferromagnetic body, at any position on the inner circumferential surface of the stator 102 or the outer circumferential surface of the rotor 101.

Therefore, as described in detail below, the inspection device 1 has a mechanism for being magnetically attracted to the ferromagnetic body at the inner circumferential surface of the stator 102, and inspects a wedge 120 (see FIG. 7) as an inspection target part provided at a groove 125 for storing a winding (not shown) of the rotor 101 of the rotating electric machine 100, while moving in the axial direction Y of the rotating electric machine 100. The wedge 120 is provided at each of grooves 125 of the rotor 101. Therefore, a plurality of wedges 120 as inspection target parts are present in the circumferential direction Z.

The inspection device 1, and the control unit 51 and the display unit 52, are connected via cables 61, 62.

The control unit 51 remotely controls the inspection device 1, and may include a user interface such as a keyboard, a mouse, a touch panel, or a joystick for receiving an input from outside. In a case where the inspection device 1, the control unit 51, and the display unit 52 all have power supplies therein and are configured to communicate signals wirelessly, the cables 61, 62 may be omitted.

In FIG. 2 and FIG. 3, the inspection device 1 includes a base frame 21, traveling bodies 111, 112, an inspection unit 20 as a radial-movement portion for the probe 31, and a circumferential-adjustment unit 30 as a circumferential-movement portion for the probe 31. The inspection unit 20 is configured to be able to move the probe 31 in the radial direction X and store the probe 31 in the base frame 21. The traveling bodies 111, 112 move the base frame 21 in the axial direction Y in the gap 103. The traveling bodies 111, 112 are connected to both ends in the circumferential direction Z of the base frame 21 via connection legs 121, 122 for connection. The connection legs 121, 122 are formed to be replaceable in accordance with the dimension of the gap 103.

The traveling bodies 111, 112 each include, for example, a crawler portion 401 which moves using a magnet and a magnetic attraction force and has a magnetic force generation device and a crawler belt, a first motor 402 which generates a driving force for the crawler portion 401, and a housing 403 storing these and formed by a nonmagnetic material such as aluminum, for example. The traveling bodies 111, 112 are attracted to the teeth 123 (see FIG. 7) of the core of the stator 102, and receive a signal from the control unit 51, to move and stop in the axial direction Y along the teeth 123 of the core of the stator 102.

The traveling bodies 111, 112 are supported by the connection legs 121, 122 so that the inspection unit 20 is located so as to keep appropriate gaps from the inner circumferential surface of the stator 102 and the outer circumferential surface of the rotor 101. The fixation positions of the connection legs 121, 122 are set so that traveling surfaces of the crawler portions 401 of the traveling bodies 111, 112 are located at the position of the core on the inner circumferential surface of the stator 102.

Movement of the traveling bodies 111, 112 may be performed by means other than the crawler portions 401, and for example, wheels may be used. In addition, an encoder may be provided and a movement distance of the crawler portion 401 may be measured by measuring rotation of the first motor 402, for example. In addition, the traveling bodies 111, 112 may be fixed so that the crawler portions 401 are opposed to the outer circumferential surface of the rotor 101 instead of the inner circumferential surface of the stator 102, and may be attached to the outer circumferential surface of the rotor 101 and moved thereon.

The inspection unit 20 includes a linear-motion portion 22, a guide arm 231, guide portions 232, 233, and link portions 241, 242, and is provided at the base frame 21. The linear-motion portion 22 is, for example, a ball screw mechanism, and includes a ball screw 221, a second motor 222 which is attached to the ball screw 221 and generates a driving force, and a bearing 223. With a signal received from the control unit 51, the second motor 222 rotates to move the guide portions 232, 233 in one degree-of-freedom direction (axial direction Y) via the ball screw 221, thereby contracting/extending the link portions 241, 242. Thus, the circumferential-adjustment unit 30 is lifted or lowered in the radial direction X, i.e., the probe 31 of the circumferential-adjustment unit 30 is moved in the radial direction X.

Operations of the linear-motion portion 22 and the link portions 241, 242 are not limited to those using the ball screw 221. For example, a mechanism such as a cylinder or a linear motor may be used, and any mechanism may be used as long as the probe 31 can be lifted, lowered, and moved in the radial direction X. A driving source therefor is not limited to electric means, and may be implemented using pneumatic, hydraulic, or manual means.

The circumferential-adjustment unit 30 includes a rack 32 and a pinion 33 as a rack-and-pinion mechanism, a third motor 34 for generating a driving force for the pinion 33, and a frame 35 having a guide groove 351, and is provided at the base frame 21.

In the circumferential-adjustment unit 30, with a signal received from the external control unit 51, the third motor 34 rotates the pinion 33 to move the probe 31 in a direction (circumferential direction Z) different from the above degree-of-freedom direction, along the rack 32 attached along the curvature of the arch shape of the frame 35. The probe 31 is supported and guided by a cam follower (not shown) and the guide groove 351, whereby loads on tooth tops of the rack 32 and the pinion 33 are reduced and dropping is prevented.

The base frame 21 and the frame 35 may have flat shapes, or may have arch shapes along the outer circumferential surface of the stator 102 or the inner circumferential surface of the rotor 101 of the rotating electric machine 100 and the arc lengths of their curved portions may be any length. The base frame 21 and the frame 35 may be provided with parts for storing the probe 31 and components such as motors, cable wires, and cables of other parts, and covers for protecting the inner surface of the rotating electric machine 100.

The inspection device 1 may be equipped with a camera facing in any direction, for the purpose of assisting remote control for operation of traveling in the axial direction Y, lifting/storing the circumferential-adjustment unit 30, and moving the probe 31 in the circumferential direction Z, and may be equipped with a lighting device for allowing clear image information to be obtained by the camera. In addition, a laser distance meter or a laser pointer may be provided for bringing the probe 31 into contact with the wedge 120 of the rotor 101 precisely, and an acceleration sensor with three or more axes may be used for detecting the orientation of the probe 31. In embodiment 1, for performing the above operations, the circumferential-adjustment unit 30 is provided with a camera 36 and a laser distance meter 37. Then, an image from the camera 36 is displayed on the display unit 52, as the state of the inspection device 1.

Regarding the structure of the probe 31, which is described later in detail, a roller 38 containing a contact medium is provided at a position that is at an axial-direction end of the probe 31 and on the front side in traveling in the axial direction Y. In addition, retainers 39 are provided at four corners of the probe 31 so that the probe 31 stably contacts with an inspection target. The roller 38 and the retainers 39 are attached to the frame 35, for example.

FIG. 4 is a schematic sectional view along the axial direction Y, showing a state in which the inspection device 1 is inserted into the gap between the stator 102 and the rotor 101 of the rotating electric machine 100. The gap 103 between the stator 102 and the rotor 101 of the rotating electric machine 100 is narrowest at an entrance 104. The inspection device 1 needs to be inserted to the inside and taken out from the inside, through the entrance 104. Therefore, when passing through the entrance 104 of the gap 103, the inspection device 1 operates the inspection unit 20 by a signal from the control unit 51, to contract the circumferential-adjustment unit 30 and the probe 31 in the radial direction X, so that the inspection device 1 passes in a state in which the circumferential-adjustment unit 30 and the probe 31 are stored. Another end portion 105 opposite to the entrance 104 in the axial direction is a point where inspection in the axial direction is finished.

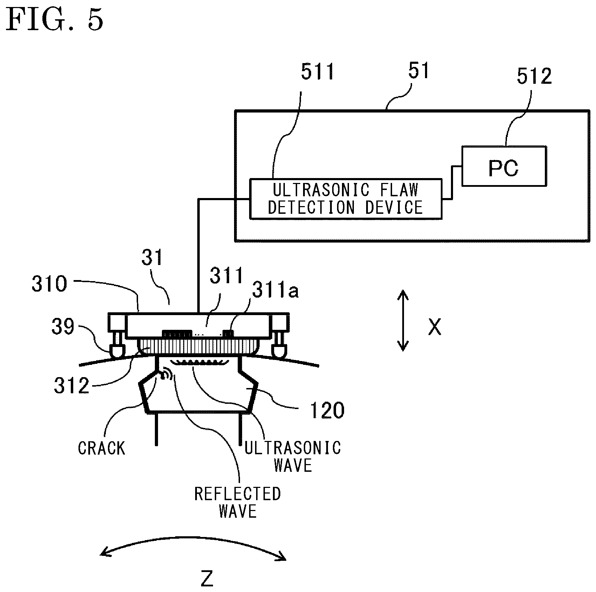

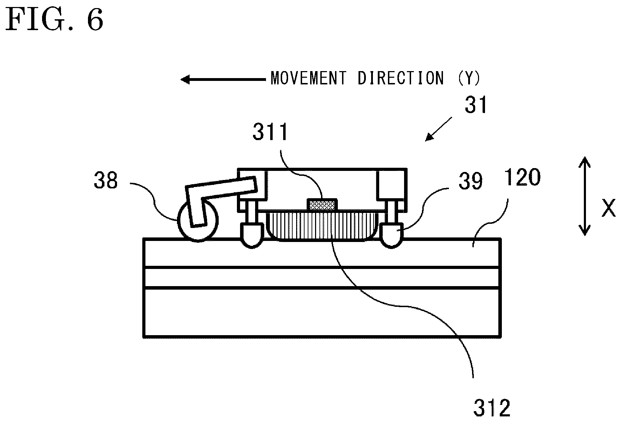

Next, the structure of the probe 31 will be described. FIG. 5 and FIG. 6 are schematic views illustrating an inspection method by the inspection device 1 using the probe 31. FIG. 5 is a sectional view as seen in the axial direction, and FIG. 6 is a sectional view along the axial direction. The probe 31 is configured such that an ultrasonic sensor 311 of a phased-array type including a plurality of ultrasonic vibrators 311a, and a shoe 312 formed by an elastic member provided at a surface on the inspection target side of the ultrasonic sensor 311, are fixed to a retention member 310.

The shoe 312 is formed by rubber in which a liquid such as oil or water is included and sealed, for example. When the inspection device 1 moves on the surface of the wedge 120 of the rotor which is an inspection target, the shoe 312 can deform along irregularities of the surface of the wedge 120 and ensures adhesion with the wedge 120 during movement.

In inspection, a contact medium (not shown) is provided between the probe 31 and the wedge 120, i.e., between the shoe 312 and the wedge 120. The contact medium is a material that provides adhesion and slidability between the shoe 312 and the wedge 120. As the contact medium, oil (e.g., salad oil) having a semi-drying or non-drying property and an insulation property is used in consideration of usage inside the rotating electric machine.

As described above, in embodiment **1,** the roller 38 containing the contact medium is provided on the front side in traveling in the axial direction Y of the inspection device 1 placed in the gap 103. As the roller 38, a paint roller that is highly hygroscopic is used, for example, and the roller 38 is immersed in the contact medium in advance so as to absorb the contact medium. In inspection, the roller 38 travels in front of the probe 31 while pressing the wedge 120, whereby the contact medium can be supplied between the shoe 312 and the wedge 120 while the inspection device 1 is traveling. Thus, since the roller 38 has the contact medium absorbed in advance, a reservoir or a supply device for supplying the contact medium is not needed, so that the size of the inspection device 1 can be reduced and inspection accuracy can be stabilized.

As described above, in embodiment **1,** the retainers 39 are provided at four corners of the probe 31 so that the probe 31 stably contacts with the inspection target during inspection. Even when the shoe 312 closely contacts with the wedge 120 in a state in which the shoe 312 is inclined along the irregularities of the surface of the wedge 120 which is the inspection target, the retainers 39 keep the wedge 120 and the probe 31 parallel to each other, thereby improving orientation stability of the shoe 312. It is desirable that the retainers 39 are provided at four corners of the probe 31, but the balance in the axial direction can be kept as long as at least two retainers 39 are provided at positions opposite to each other in the axial direction across the probe 31.

The control unit 51 includes an ultrasonic flaw detection device 511 for performing control to emit an ultrasonic wave from the ultrasonic sensor 311 of a phased-array type and receive a reflected wave. In addition, a personal computer (PC) 512 or the like may be provided in order to operate the ultrasonic flaw detection device 511 and communicate acquired cross-section data.

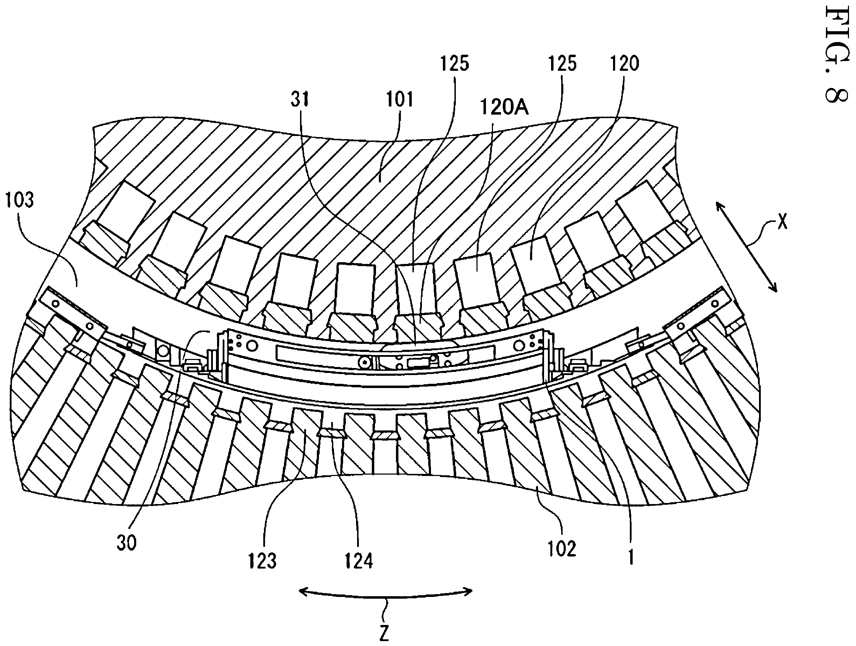

FIG. 7 and FIG. 8 are schematic sectional views along the radial direction X, showing the inspection device 1 placed in the gap 103 between the rotor 101 and the stator 102 of the rotating electric machine 100 in embodiment 1. Here, the shoe 312, the roller 38, and the retainers 39 of the probe 31 are not shown. The stator 102 has grooves 124 arranged discontinuously on the inner circumferential surface in the core formed by a ferromagnetic body, and the traveling bodies are attracted along the teeth 123 of the core at the inner circumferential surface of the stator 102. The wedges 120 of the rotor 101 are located so as to be opposed to the stator 102, and the positional relationship thereof relative to arrangement of the grooves 124 of the stator 102 is indefinite in the circumferential direction Z. The circumferential-adjustment unit 30 is configured to move the probe 31 in the circumferential direction Z in the inspection device 1 so that the probe 31 is opposed to the surface of the wedge 120 of the rotor 101, thus enhancing the contact property.

When the probe 31 is pressed to the surface of an inspection target wedge 120A among the wedges 120 of the rotor 101, for example, current of the second motor 222 for the ball screw 221 is controlled and limited, whereby the force of pressing the probe 31 is controlled. In addition, control is performed so as to finely change the contact state of the probe 31 and prevent destruction of a mechanism element.

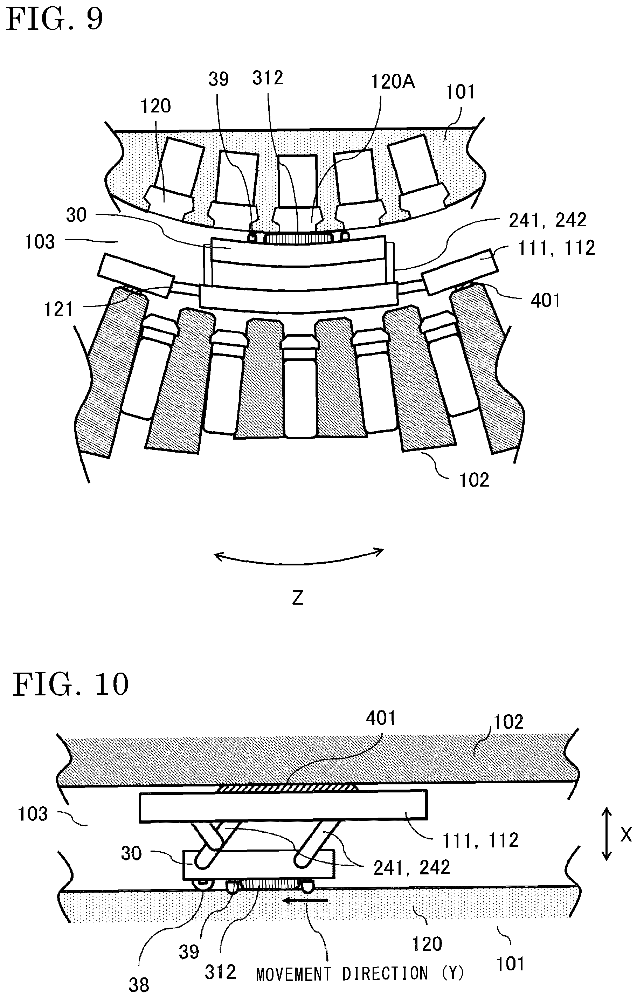

FIG. 9 is a schematic enlarged view showing a part of FIG. 8. The crawler portions 401 of the traveling bodies 111, 112 are located at the position of the core on the inner circumferential surface of the stator 102, and the shoe 312 of the probe 31 lifted from the link portions 241, 242 and closely contacting with the surface of the inspection target wedge 120A is balanced by the retainers 39.

FIG. 10 is a schematic view showing a cross-section along the axial direction Y, of the inspection device 1 in a state of inspecting the wedge 120 of the rotor 101 of the rotating electric machine 100. In inspecting the wedge 120 at the surface of the rotor 101, the shoe 312 of the probe 31 is moved to a surface position of the wedge 120 of the rotor 101 at an inspection start point near the entrance 104 of the gap 103, so as to come into contact with the wedge 120, whereby inspection is started. The probe 31 is moved with the shoe 312 pressed, from the inspection start point on the wedge 120 near the entrance 104 of the gap 103 to an inspection finish point at the other end portion 105. The roller 38 containing the contact medium is present on the front side in the movement direction, and the contact medium is supplied to contact surfaces of the shoe 312 and the wedge 120, so that movement is smoothly performed.

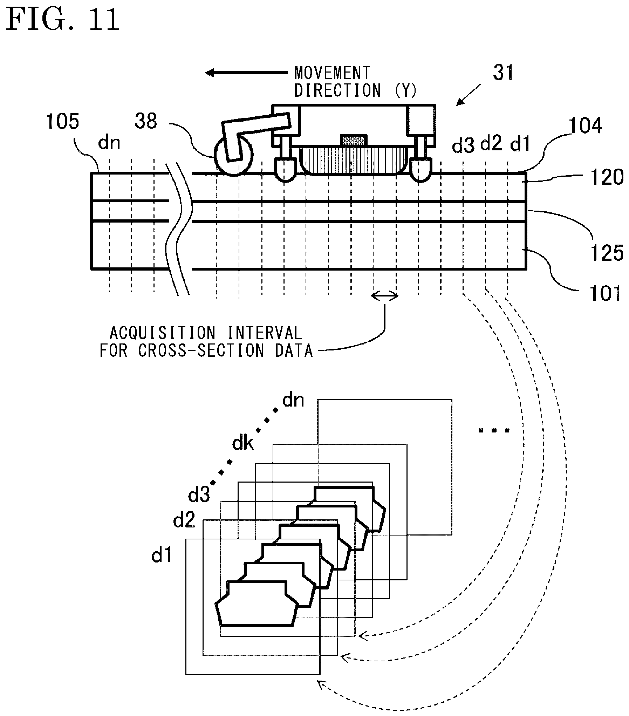

Next, an acquisition method for inspection data will be described. FIG. 11 schematically shows a cross-section along the axial direction Y, of the inspection device 1 in a state of inspecting the wedge 120 of the rotor 101 of the rotating electric machine 100, and also shows acquired data. Cross-section data are acquired at predetermined intervals from the inspection start point near the entrance 104 of the gap 103. The cross-section data are images based on an ultrasonic wave emitted from the ultrasonic sensor 311 and a reflected wave reflected by a crack or the like, at a certain point, as shown in FIG. 5. The cross-section data are acquired at set intervals, as an image d1 at the start point, an image d2, ..., an image dk (k is an integer greater than 1), and are acquired up to an image dn (n is an integer, k ≤ n) at the inspection finish point. Thus, by acquiring, along the axial direction, two-dimensional data of cross-sections, it becomes possible to generate three-dimensional data, whereby the state of a crack occurring in the wedge can be obtained accurately.

The intervals for acquiring image data may be set in accordance with the movement distance, for example. Image data may be acquired at equal intervals with the length of the wedge 120 in the axial direction equally divided, or the intervals may be set at unequal intervals such that the intervals are shortened at a part where a crack is likely to occur on the basis of past data. Alternatively, distance information of an encoder provided to the first motor 402 for driving the traveling bodies 111, 112 may be used. Image data may be acquired on the basis of time intervals. For example, the intervals may be set by a timer in synchronization with the movement speed.

Movement is performed with the shoe 312 pressed. Image data may be acquired while the shoe 312 is pressed in synchronization with the movement speed and the movement distance, by making the pressure smaller during movement than at the time of inspection. Therefore, a pressure sensor or a strain gauge may be provided to the retention member 310 for retaining the ultrasonic sensor 311, to measure the pressure, and the pressure may be controlled.

In the present embodiment **1,** inspection is performed by acquiring, along the axial direction, a plurality of cross-section data, while the probe 31 is moved in the axial direction. Therefore, as shown in FIG. 5 and FIG. 9, at least, the width in the circumferential direction of the shoe 312 is set to be equal to or greater than the width in the circumferential direction of the contacted wedge 120. If the width in the circumferential direction of the shoe 312 is smaller than the width in the circumferential direction of the contacted wedge 120, an ultrasonic wave does not reach some parts inside the wedge 120, so that oversight might occur in inspection. If the width in the circumferential direction of the shoe 312 is extremely great, an ultrasonic wave is emitted also to a part where the wedge 120 is not present, and therefore the ultrasonic wave cannot be used efficiently. In addition, since image data are acquired through movement in the axial direction of the wedge 120, when shift in movement in the axial direction is also taken into consideration, it is preferable that the width in the circumferential direction of the shoe 312 is greater than the width in the circumferential direction of the wedge 120 and ends in the circumferential direction of the shoe 312 are approximately within the centers of the circumferential-direction intervals of the wedges 120. However, since the shoe 312 serves as a contact medium for efficiently emitting an ultrasonic wave, the width in the circumferential direction of the ultrasonic sensor 311 may be smaller than the width of the wedge 120.

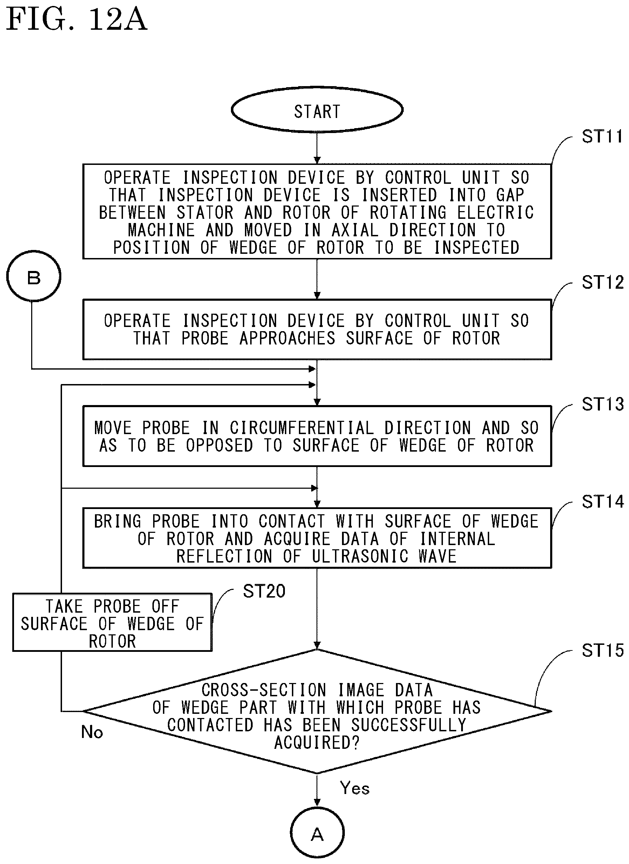

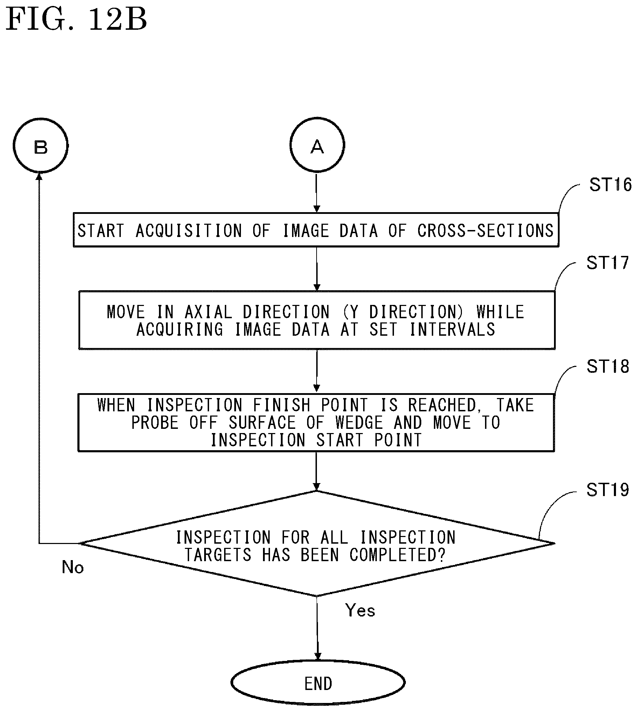

Next, an inspection method by the rotating electric machine inspection device 1 in embodiment 1 configured as described above will be described with reference to the drawings. FIG. 12A and FIG. 12B are flowcharts showing the inspection method by the rotating electric machine inspection device in embodiment 1. In embodiment 1, an example of performing full inspection for inspection target parts is shown. The order of movement of the probe 31 in steps in the flowcharts is merely an example, and may be changed as long as inspection for inspection target parts is achieved.

First, the inspection device 1 of the inspection system 10 is operated by the control unit 51, to be brought and inserted through the entrance 104 of the rotating electric machine 100 into the gap 103 between the rotor 101 and the stator 102. At this time, the inspection device 1 may be placed at the inner circumferential surface of the stator 102 or the outer circumferential surface of the rotor 101. Then, the inspection device 1 is operated by the control unit 51, to be moved in the axial direction Y to the position of the wedge 120 at the inspection target part of the rotor 101 (step ST11).

Next, in the inspection device **1,** the circumferential-adjustment unit 30 including the probe 31 is lifted in the radial direction X so as to approach the surface of the rotor 101 by the linear-motion portion 22 and the link portions 241, 242 of the inspection unit 20, through operation by the control unit 51 (step ST12). Next, the third motor 34 connected to the pinion 33 of the circumferential-adjustment unit 30 is operated by the control unit 51, to move the probe 31 in the circumferential direction Z to a position opposed to the surface of the wedge 120 at the inspection target part of the rotor 101 (step ST13). This position is the inspection start point. Thus, even if the position in the circumferential direction Z of the probe 31 of the inspection device 1 at the time of initial insertion is shifted from the position in the circumferential direction Z of the wedge 120, the probe 31 can be assuredly placed at the position opposed to the wedge 120.

Next, the shoe 312 of the probe 31 is brought into contact with the surface of the wedge 120 of the rotor 101, to acquire data of internal reflection of an ultrasonic wave (step ST14). At this time, if appropriate image data has been successfully acquired (Yes in step ST15), this image data is used as data at the inspection start point and inspection is started (step ST16). If the data acquired in step ST14 is inappropriate, e.g., a part of the cross-section image of the target wedge 120 is lacking because the position of the probe 31 in the circumferential direction is shifted, or an ultrasonic wave is not stable, the probe 31 is taken off the surface of the wedge 120 once (step ST20), and the process returns to step ST13 or step ST14 to acquire reflection data again. The step to which the process returns may be determined on the basis of the image in step ST15, e.g., the process returns to step ST13 in a case where there is a great shift in the circumferential direction and thus position adjustment of the probe 31 in the circumferential direction is needed, or the process returns to step ST14 in a case of merely adjusting the balance of the shoe 312.

In step ST16, acquisition of image data of cross-sections is started, and then, with the shoe 312 of the probe 31 pressed, movement is performed from the entrance 104 of the gap 103 toward the other end portion 105, while image data are acquired at predetermined intervals (step ST17). When the inspection finish point on the other end side opposite to the inspection start point of the wedge 120 is reached, the shoe 312 of the probe 31 is taken off the surface of the wedge 120 and is moved in the axial direction to the inspection start point (step ST18). Thus, one axial-direction inspection for the wedge 120 is finished. If there is another inspection target wedge 120 (No step ST19), inspection is performed from step ST13 again. In this case, in step ST13, the probe 31 is moved in the circumferential direction Z to a position opposed to the other wedge 120. If there are no other inspection target wedges 120 (Yes in step ST19), inspection for all the inspection targets is completed. In the rotating electric machine 100 in the present disclosure, the inspection device 1 inspects the rotating electric machine 100 by acquiring image data along the axial direction, whereby the inspection time can be shortened and efficient operation of the rotating electric machine 100 can be achieved.

As described above, the rotating electric machine inspection device of embodiment 1 is a rotating electric machine inspection device which inspects an inspection target part by being inserted into a gap between an inner circumferential surface of a stator and an outer circumferential surface of a rotor of a rotating electric machine, the rotating electric machine inspection device including: a base frame; a traveling body which is attached to the base frame and moves the base frame in an axial direction in the gap; a probe which inspects the inspection target part and has an ultrasonic sensor of a phased-array type and a shoe provided at one surface of the ultrasonic sensor and formed by an elastic member; a radial-movement portion which moves the probe in a radial direction perpendicular to the axial direction and a circumferential direction; a circumferential-movement portion which moves the probe in the circumferential direction in the base frame; and a roller provided at an end in the axial direction of the probe and containing a contact medium, wherein the probe inspects the inspection target part along the axial direction in a state in which a side where the roller is provided is set as a front side. Thus, while the probe moves in the axial direction, image data of the inspection target can be acquired along the axial direction, whereby efficiency of inspection work can be improved and an inspection work period can be shortened.

In addition, since the contact medium is supplied between the shoe of the probe and the surface of the inspection target part from the roller located on the front side in movement of the probe, the probe can contact with the surface of the inspection target part appropriately, whereby a signal obtained in accordance with a defect at the surface of the inspection target part or inside thereof can become more accurate.

In addition, since the probe can be moved in the circumferential direction in the inspection device, one or a plurality of inspection target parts can be inspected, constraints on movement of the inspection device can be reduced, efficiency of inspection work can be improved, and an inspection work period can be shortened.

In addition, since the probe can be moved in the circumferential direction in the inspection device, even if the inspection device is stopped at any position in the circumferential direction, the positional relationship between the inspection target part and the probe can be adjusted to be appropriate, and the probe can be brought into contact with the surface of the inspection target part appropriately. In addition, the frequency at which rotor position adjustment work is performed and the inspection device is placed again for inspection, can be reduced, the inspection can be facilitated, and the inspection can be performed in a short period.

In addition, since the probe can be moved in the circumferential direction in the inspection device, even if the inspection device is stopped at any position in the circumferential direction, the positional relationship between the inspection target part and the probe can be adjusted to be appropriate, and the probe can be brought into contact with the surface of the inspection target part appropriately. In addition, the frequency at which rotor position adjustment work is performed and the inspection device is placed again for inspection, can be reduced, the inspection can be facilitated, and the inspection can be performed in a short period. Further, since the probe can contact with the surface of the inspection target part appropriately, a signal obtained in accordance with a defect at the surface of the inspection target part or inside thereof can become more accurate.

The rotating electric machine inspection device of embodiment 1 further includes retainers which are provided at positions opposite to each other in the axial direction across the probe and stabilize an orientation of the shoe, and desirably, the retainers are provided at four corners of the probe. Thus, even when the shoe closely contacts with the inspection target part in a state in which the shoe is inclined along the irregularities on the inspection target part, the retainers keep the surface of the inspection target and the probe parallel to each other, thereby improving orientation stability of the shoe. Thus, reduction in inspection accuracy can be suppressed.

In the rotating electric machine inspection device of embodiment 1, a width in the circumferential direction of the shoe is set to be equal to or greater than a width in the circumferential direction of the inspection target part. Thus, a cross-section portion of the inspection target part can be inspected at one time, and at the time of movement in the axial direction, even if shift has occurred, there is no influence on inspection accuracy as long as the shift is within the difference between the width in the circumferential direction of the inspection target part and the width in the circumferential direction of the shoe. That is, if the width in the circumferential direction of the shoe is small, it is necessary to perform movement in the circumferential direction in order to inspect the same cross-section portion of the inspection target part a plurality of times, so that inspection, movement in the circumferential direction, movement in the axial direction, inspection, movement in the circumferential direction, ..., are repeated. As a result, movement is complicated and an adjustment time for moving to an appropriate position is required. The present embodiment 1 solves this problem and makes it possible to perform inspection through only movement in the axial direction.

The traveling body is attached to the base frame via a connection leg for connection, and the connection leg is formed to be replaceable in accordance with a dimension of the gap. Thus, since the connection leg can be replaced in accordance with the dimension of the gap in the rotating electric machine, versatility of the inspection device is enhanced.

The radial-movement portion is configured to be able to move the probe in the radial direction and store the probe in the base frame. Thus, the probe can be prevented from obstructing insertion of the inspection device into the gap of the rotary electric machine.

The traveling body includes a crawler portion which, using a magnetic attraction force, moves along a ferromagnetic body at the inner circumferential surface of the stator or the outer circumferential surface of the rotor of the rotating electric machine, and a first motor which generates a driving force for the crawler portion. Thus, movement of the inspection device in the axial direction can be easily performed.

The radial-movement portion controls a force for pressing the probe to the inspection target part. Thus, the probe can contact with the inspection target part as appropriate without damaging the inspection target part or another part.

The radial-movement portion includes a linear-motion portion which operates in the axial direction, and a link portion which moves in the radial direction while linking with operation of the linear-motion portion, and the linear-motion portion includes a ball screw and a second motor which generates a driving force for the ball screw. Thus, movement of the probe in the radial direction can be assuredly performed.

The circumferential-movement portion is formed by a rack-and-pinion mechanism having a rack and a pinion, and includes a third motor which generates a driving force for the pinion. Thus, movement of the probe in the circumferential direction can be assuredly and easily performed.

The rotating electric machine inspection device system of embodiment 1 includes: the rotating electric machine inspection device according to embodiment 1 described above; a control unit which controls movement of the probe of the inspection device in at least one of the circumferential direction and the radial direction; and a display unit which displays a state of the inspection device. Thus, it is possible to achieve a rotating electric machine inspection device system that has high accuracy and enables an inspection time to be shortened as compared to the conventional one.

The control unit acquires, along the axial direction, a plurality of image data of cross-sections of the inspection target part at predetermined intervals. Thus, it becomes possible to easily determine a defect part, so that inspection accuracy is improved. In addition, it becomes possible to generate three-dimensional data by connecting acquired data in the axial direction through image processing, leading to further improvement in inspection accuracy.

The rotating electric machine inspection method of embodiment 1 is a rotating electric machine inspection method in which, using the rotating electric machine inspection device according to embodiment 1 described above, a plurality of inspection target parts at different locations in the circumferential direction are inspected in the axial direction in a state in which the rotor and the stator of the rotating electric machine are combined, the rotating electric machine inspection method comprising the steps of: inserting the inspection device into the gap between the stator and the rotor and moving the inspection device to one of the inspection target parts; performing inspection at predetermined intervals in the axial direction from a start point of the one inspection target part, by the probe; performing movement along the axial direction to the start point, when an inspection finish point of the one inspection target part is reached; and moving the probe so as to be opposed to another one, of the inspection target parts, that is different from the one inspection target part and is included in a range where the probe is movable in the circumferential direction in the inspection device, and inspecting the other inspection target part. Thus, image data of the inspection target can be acquired along the axial direction, whereby efficiency of inspection work can be improved and an inspection work period can be shortened.

The step of performing inspection by the probe includes a step of moving the probe to a position opposed to the inspection target part, a step of moving the probe to a surface of the inspection target part, and a step of performing movement in the axial direction in a state in which the probe is in contact with the surface of the inspection target part. Thus, it becomes unnecessary to repeat operations of pushing the probe against the inspection target part and taking the probe off the inspection target part in inspection in the axial direction, leading to further shortening of the inspection work period.

The control unit 51 is composed of a processor 200 and a storage device 201 as shown in FIG. 14 which shows a hardware example thereof. Although not shown, the storage device is provided with a volatile storage device such as a random access memory and a nonvolatile auxiliary storage device such as a flash memory. Instead of the flash memory, an auxiliary storage device of a hard disk may be provided. The processor 200 executes a program inputted from the storage device 201. In this case, the program is inputted from the auxiliary storage device to the processor 200 via the volatile storage device. The processor 200 may output data such as a calculation result to the volatile storage device of the storage device 201 or may store such data into the auxiliary storage device via the volatile storage device.

In the above description, the circumferential-movement portion for moving the probe in the circumferential direction in the base frame has been described. However, a circumferential-adjustment portion may be provided which moves the traveling body within the range of the width in the circumferential direction of the tooth of the stator, to adjust the position in the circumferential direction of the probe relative to the inspection target part. The circumferential-adjustment portion is obtained by a known circumferential-direction movement mechanism as described in US Patent Application Publication No. 2007/0089544, for example, but is not limited thereto.

The circumferential-adjustment portion adjusts the position in the circumferential direction of the probe relative to the inspection target part so as to compensate for a phase shift between the rotor and the stator. Here, the phase shift is, for example, a shift of the probe relative to the wedge at the inspection target part, and is a shift within the range of the width in the circumferential direction of the tooth of the stator. Thus, providing the circumferential-adjustment portion for adjusting the position in the circumferential direction of the probe within the range of the width in the circumferential direction of the tooth of the stator enables the probe to be opposed to the wedge at the inspection target part more accurately.

### <Other embodiments>

In the above embodiment 1, the example in which the inspection target part is a wedge of the rotor has been described. However, the inspection device, the inspection system, and the inspection method according to the present disclosure are applicable also in a case of targeting a tooth portion (tooth) located between adjacent wedges. The example in which the inspection device 1 travels on the stator has been described. However, the inspection device 1 may travel on the rotor.

It has been described that image data are acquired along the axial direction. These image data may be accumulated to perform comparison with past data. Performing comparison or calculating a difference in image data at the same part prevents a defect from being overlooked. Further, a sign for occurrence of a defect can be detected and planning information for an inspection schedule can be provided.

It has been described that the width in the circumferential direction of the shoe is set to be equal to or greater than the width in the circumferential direction of the inspection target. Here, the width in the circumferential direction of the shoe may be determined in consideration of a case where a plurality of rotating electric machines are inspected by one inspection device. For example, the rotating electric machines may be grouped in accordance with sizes thereof, and then the width in the circumferential direction of the shoe may be determined by the greatest value of the widths in the circumferential direction of inspection targets in the group.

The example in which the roller and the retainers are attached to the frame of the circumferential-adjustment unit has been described, but the present disclosure is not limited thereto. For example, they may be attached to the retention member of the probe.

Although the disclosure is described above in terms of exemplary embodiments, it should be understood that the various features, aspects, and functionality described in the embodiment are not limited in their applicability to the particular embodiment with which they are described, but instead can be applied alone or in various combinations to the embodiments of the disclosure.

It is therefore understood that numerous modifications which have not been exemplified can be devised without departing from the scope of the present disclosure. For example, at least one of the constituent components may be modified, added, or eliminated.

### DESCRIPTION OF THE REFERENCE CHARACTERS

- 1: inspection device
- 10: inspection system
- 100: rotating electric machine
- 101: rotor
- 102: stator
- 103: gap
- 104: entrance
- 105: other end portion
- 111: traveling body
- 112: traveling body
- 120: wedge
- 120A: wedge
- 121: connection leg
- 122: connection leg
- 123: tooth
- 124: groove
- 125: groove
- 20: inspection unit
- 200: processor
- 201: storage device
- 21: base frame
- 22: linear-motion portion
- 221: ball screw
- 222: second motor

- 223: bearing
- 231: guide arm
- 232: guide portion
- 233: guide portion
- 241: link portion
- 242: link portion
- 30: circumferential-adjustment unit
- 31: probe
- 310: retention member
- 311: ultrasonic sensor
- 311a: ultrasonic vibrator
- 312: shoe
- 32: rack
- 33: pinion
- 34: third motor
- 35: frame
- 351: guide groove
- 36: camera
- 37: laser distance meter
- 38: roller
- 39: retainer
- 401: crawler portion
- 402: first motor
- 403: housing
- 51: control unit

- 511: ultrasonic flaw detection device
- 512: PC (personal computer)
- 52: display unit
- 61: cable
- 62: cable
- X: radial direction
- Y: axial direction
- Z: circumferential direction

## Claims

1. A rotating electric machine inspection device which inspects an inspection target part by being inserted into a gap between an inner circumferential surface of a stator and an outer circumferential surface of a rotor of a rotating electric machine, the rotating electric machine inspection device comprising:
a base frame;
a traveling body which is attached to the base frame and moves the base frame in an axial direction in the gap;
a probe which inspects the inspection target part and has an ultrasonic sensor of a phased-array type and a shoe provided at one surface of the ultrasonic sensor and formed by an elastic member;
a radial-movement portion which moves the probe in a radial direction perpendicular to the axial direction and a circumferential direction;
a circumferential-movement portion which moves the probe in the circumferential direction in the base frame; and
a roller provided at an end in the axial direction of the probe and containing a contact medium, wherein
the probe inspects the inspection target part along the axial direction in a state in which a side where the roller is provided is set as a front side.

2. The rotating electric machine inspection device according to claim **1,** further comprising retainers which are provided at positions opposite to each other in the axial direction across the probe and stabilize an orientation of the shoe.

3. The rotating electric machine inspection device according to claim 2, wherein
the retainers are provided at four corners of the probe.

4. The rotating electric machine inspection device according to any one of claims 1 to 3, wherein
a width in the circumferential direction of the shoe is equal to or greater than a width in the circumferential direction of the inspection target part.

5. The rotating electric machine inspection device according to any one of claims 1 to 4, wherein
the traveling body is attached to the base frame via a connection leg for connection, and
the connection leg is formed to be replaceable in accordance with a dimension of the gap.

6. The rotating electric machine inspection device according to any one of claims 1 to 5, wherein
the radial-movement portion is configured to be able to move the probe in the radial direction and store the probe in the base frame.

7. The rotating electric machine inspection device according to any one of claims 1 to 6, wherein
the traveling body includes
a crawler portion which, using a magnetic attraction force, moves along a ferromagnetic body at the inner circumferential surface of the stator or the outer circumferential surface of the rotor of the rotating electric machine, and
a first motor which generates a driving force for the crawler portion.

8. The rotating electric machine inspection device according to any one of claims 1 to 7, wherein
the radial-movement portion controls a force for pressing the probe to the inspection target part.

9. The rotating electric machine inspection device according to any one of claims 1 to 8, wherein
the radial-movement portion includes a linear-motion portion which operates in the axial direction, and a link portion which moves in the radial direction while linking with operation of the linear-motion portion, and
the linear-motion portion includes a ball screw and a second motor which generates a driving force for the ball screw.

10. The rotating electric machine inspection device according to any one of claims 1 to 9, wherein
the circumferential-movement portion is formed by a rack-and-pinion mechanism having a rack and a pinion, and includes a third motor which generates a driving force for the pinion.

11. A rotating electric machine inspection system comprising:
the rotating electric machine inspection device according to any one of claims 1 to 10;
a control unit which controls movement of the probe of the inspection device in at least one of the circumferential direction and the radial direction; and
a display unit which displays a state of the inspection device.

12. The rotating electric machine inspection system according to claim 11, wherein
the control unit acquires, along the axial direction, a plurality of image data of cross-sections of the inspection target part at predetermined intervals.

13. A rotating electric machine inspection method in which, by the rotating electric machine inspection device according to any one of claims 1 to 10, a plurality of inspection target parts at different locations in the circumferential direction are inspected in the axial direction in a state in which the rotor and the stator of the rotating electric machine are combined, the rotating electric machine inspection method comprising the steps of:
inserting the inspection device into the gap between the stator and the rotor and moving the inspection device to one of the inspection target parts;
performing inspection at predetermined intervals in the axial direction from a start point of the one inspection target part, by the probe;
performing movement along the axial direction to the start point, when an inspection finish point of the one inspection target part is reached; and
moving the probe so as to be opposed to another one, of the inspection target parts, that is different from the one inspection target part and is included in a range where the probe is movable in the circumferential direction in the inspection device, and inspecting the other inspection target part.

14. The rotating electric machine inspection method according to claim 13, wherein
the step of performing inspection by the probe includes
a step of moving the probe to a position opposed to the inspection target part,
a step of moving the probe to a surface of the inspection target part, and
a step of performing movement in the axial direction in a state in which the shoe of the probe is in contact with the surface of the inspection target part.
